# EUROPÄISCHE PATENTSCHRIFT

(11) **EP 0 873 258 B1**
(45) Veröffentlichungstag und Bekanntmachung des Hinweises auf die Patenterteilung: **05.12.2001**
(21) Anmeldenummer: 97900995.8
(22) Anmeldetag: 10.01.1997
(51) Int. Cl.: B62D 15/02, G01D 5/245, H03M 1/00

(54) **LENKWINKELSENSOR MIT AUSWERTUNG DER INKREMENTALSPUR ZUR ABSOLUTWERTBESTIMMUNG**
STEERING-ANGLE SENSOR WITH EVALUATION OF THE INCREMENTAL TRACK FOR ABSOLUTE VALUE DETERMINATION
CAPTEUR D'ANGLE DE BRAQUAGE AVEC SYSTEME D'EVALUATION DE LA PISTE INCREMENTIELLE POUR LA DETERMINATION DE LA VALEUR ABSOLUE

(30) Priorität: 18.01.1996 DE 19601676
(43) Veröffentlichungstag der Anmeldung: 28.10.1998
(73) Patentinhaber: Valeo Schalter und Sensoren GmbH, 74321 Bietigheim-Bissingen (DE)
(72) Erfinder: NECKEL, Klaus, D-71665 Vaihingen (DE); WIGGER, Bernd, D-74366 Kirchheim (DE)
(74) Vertreter: Dreiss, Fuhlendorf, Steimle & Becker
(86) Internationale Anmeldenummer: EP9700096
(87) Internationale Veröffentlichungsnummer: WO9726174

(56) Entgegenhaltungen:
- EP-A- 0 738 879
- WO-A-96/28335
- WO-A-97/01078
- WO-A-97/09588
- DE-A- 4 009 007
- DE-A- 4 041 491
- DE-A- 4 136 888
- DE-A- 4 409 892

## Beschreibung

Die Erfindung betrifft einen Lenkwinkelsensor zur Bestimmung des Absolutwerts des Fahrzeuglenkwinkels, mit Auswertung der Inkrementalspur zur Absolutwertbestimmung.

Zur Fahrstabilitätsregelung ist es notwendig, neben anderen Parametern auch den gerade vorliegenden Lenkwinkel des Fahrzeugs zu kennen. Da dieser Lenkwinkel von der Drehlage des Lenkrades abhängt, ist man dazu übergegangen, den Lenkwinkel mit Hilfe der Drehstellung des Lenkrads eines Fahrzeugs zu bestimmen. Hierzu ist das Lenkrad mit einem Modulator gekoppelt, welcher ein Dauersignal in Abhängigkeit von der Drehstellung des Lenkrades moduliert. Dies kann durch die Modulation eines konstanten magnetischen Feldes oder auch eines konstanten Lichtstroms geschehen. Im vorliegenden Fall wird davon ausgegangen, daß ein Lichtstrom durch die Zähne einer Codescheibe moduliert wird. Dabei sind die Zähne in zwei kreisförmigen Spuren angeordnet. Während die erste Spur als Inkrementalspur eine Anzahl gleichmäßig auf dem Kreisumfang verteilter Zähne aufweist, die durch zwei um 90° (eine Zahnperiode = 360°) versetzte Sensoren abgetastet wird, besitzt die sogenannte Absolutspur einen auf einen Kreisumfang verteilten Kettencode, welcher den Absolutwert der Scheibenstellung angibt. Einzelheiten hierzu sind in der DE-A-19532903 bzw. in der WO-A-97/05988 (EP-A-0 848 804) beschrieben worden, die druckschriftlich nicht vorveröffentlicht sind und wobei letztere einen Stand der Technik nach Artikel 54(3) und (4) EPÜ bildet und in ihren Merkmalen denjenigen des Oberbegriffs des Anspruchs 1 entspricht; gemäß der Beschreibung wird es als wichtig erachtet, daß die Flanken der Codes der Absolutspar gegenüber denen der Inkrementalspuren um einen bestimmten Winkel verschoben sind. Der Hintergrund für die Wahl der beiden genannten Spuren besteht darin, daß durch die Inkrementalspur über die zwei Sensoren sowohl die Drehrichtung des Lenkrades als auch die augenblicklichen schrittweisen Winkeländerungen in der Lenkradstellung bestimmt werden können. Andererseits ist es aus diesen Angaben nicht möglich, beim Einschalten der Messung beispielsweise beim Starten des Fahrzeugs festzustellen, welche Winkelstellung das Lenkrad anfänglich annimmt, da hier nur relative Änderungen nur bestimmt werden können. wenn die zur Lenkwinkelbestimmung notwendige Stromversorgung eingeschaltet und zumindest eine kleine Drehwinkeländerung an dem Lenkrad vorgenommen wurde.

In der o.g. Patentanmeldung wurde vorgeschlagen, hinsichtlich das Absolutwertes eine Auflösung von 1,5° zu haben, was einer Zähnezahl auf der Inkrementalspur von 60 Zähnen entspricht. Für die Schrittzahl des Absolutwertcodes wurden 240 Schritte festgelegt, so daß sich ein Initialisierungswinkel bei insgesamt drei Sensoren von 12° ergibt.

Um nun auf der Absolutspur mindestens 240 unterschiedliche Werte definierten zu können, ist ein Code von 8 Bit notwendig, der die Definition von maximal 256 Schritten erlaubt. Eine derart große Schrittzahl ist bei einer vergleichsweise kleinen Codescheibe nur unter der Wahl vergleichsweise hoher Toleranzen herstellbar und damit recht aufwendig.

Die Erfindung geht daher aus von einem Lenkwinkelsensor der sich aus dem Oberbegriff des Anspruchs 1 ergebenden Gattung. Aufgabe der Erfindung ist es, die Anzahl der für die Schrittzahl eines Codes benötigten Bits auf der Absolutspur herabzusetzen.

Die Aufgabe wird durch die sich aus dem kennzeichnenden Teil des Anspruchs 1 ergebende Merkmalskombination gelöst. Die Erfindung besteht im Prinzip also darin, zur Bestimmung des tatsächlich vorliegenden Absolutwerts des Lenkradwinkels nicht nur die Codespur selbst, sondern auch die augenblickliche Stellung der Inkrementalspur gegenüber den beiden diese Spur abtastenden Sensoren auszunutzen, indem die Richtung des Flankenwechsels der von ihnen erzeugten Signale ausgewertet wird. Auf diese Weise ist es möglich, mindestens 1 Bit der benötigten 8 Bit aus der Inkrementalspur zu entnehmen. Vorteilhafte Weiterbildungen zeigen, daß zusätzlich auch noch ein zweites Bit dem Zustand der Inkrementalspur entnommen werden kann, so daß auf der Absolutspur 2 Bit eingespart werden können und dort die Auswertung von 6 Bit genügt. Es reicht somit aus, auf der Absolutspur 60 anstatt 240 Werte zu codieren.

Weiter oben war schon gesagt worden, daß durch die Anwendung der Merkmale nach Anspruch 1 mindestens 1 Bit der Codierung der Absolutspur eingespart werden kann. Daraus resultiert, daß bei gleicher Auflösung sich die Anzahl der ausschließlich durch die Absolutspur bestimmbaren Werte halbiert.

Um auch die Drehrichtung des Lenkrads zu erkennen, empfiehlt sich in Weiterbildung der Erfindung die Anwendung der Merkmalskombination nach Anspruch 2. Gemäß Anspruch 3 hat es sich als zweckmäßig herausgestellt, den tatsächlichen absoluten Lenkwinkel, also den mit Hilfe der Inkrementalspur und der Absolutspur bestimmbaren Absolutwert durch 8 Bit zu definieren, wodurch sich ohne Schwierigkeiten 240 unterschiedliche Werte ausdrücken lassen, was einer Auflösung von 1,5° entspricht. Eine derartige Auflösung ist für die heute gängigen Regeleinrichtungen zur Regelung der Fahrstabilität durchaus hinreichend. Die Erfindung ist aber auch dann zweckmäßig, wenn eine größere Auflösung erwünscht ist.

Wendet man die Merkmale der Ansprüche 2 und 3 an, so kann man entsprechend der Merkmalskombination nach Anspruch 4 die Definition des Absolutwertes hinsichtlich der Absolutspur auf 6 Bit begrenzen und die benötigen zwei zusätzlichen Bit den beiden Ausgangssignalen der Inkrementalsensoren entnehmen. Da der sechsstellige Code auf der Absolutwertspur ein Kettencode sein soll, kommt man auf der Absolutspur mit etwa 70 Schritten aus, was die Herstellung der Codescheibe stark vereinfacht.

Die Wahl der Codewerte auf der Absolutspur ist durch die Verwendung eines Kettencodes stark eingeschränkt, da sich ja jeweils sechs hintereinander gelesene Bit auf der Spur nicht wiederholen sollen. Um nun diesen sich sprunghaft ändernden Codewerten in Schritten sich ändernde absolute Winkelwerte zuzuordnen, empfiehlt sich in Weiterbildung der Erfindung die Merkmalskombination nach Anspruch 6.

Ein Ausführungsbeispiel der Erfindung wird nachfolgend anhand der Zeichnung erläutert. Darin zeigt:
- Fig. 1: in schematischer Darstellung die Aufteilung der Spuren auf einer Codescheibe
- Fig. 2 bis 4: die Ausgangssignale an den einzelnen Detektoren und
- Fig. 5 bis 7: die Zusammensetzung des aus 8 Bit bestehenden Codeworts aus den Inhalten der einzelnen Spuren.

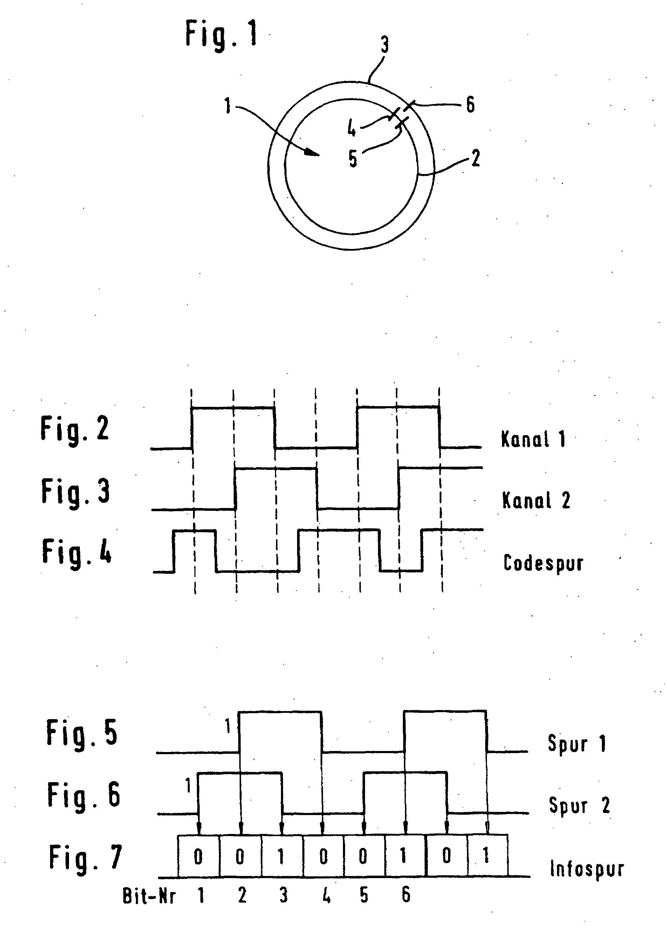

Fig. 1 zeigt eine Codescheibe 1 mit einer innenliegenden Inkrementalspur 2 und einer außenliegenden Codespur 3 zur Darstellung des Absolutwertcodes. Die Spuren weisen einzelne Zähne auf, die bei der Inkrementalspur 2 gleichmäßig über den Kreisumfang verteilt sind, während in der Codespur 3 das Vorhandensein oder Nichtvorhandensein eines Zahns für jeweils 1 Bit eines sechsschrittigen Codes steht. Die Folge von Zähnen bzw. Zahnlücken auf der Codespur 2 stellt somit immer ein aus sechs Schritten bestehendes Codewort dar, wobei sich mindestens 60 Codeworte ergeben, deren Anfang jeweils um eine Zahnbreite versetzt beginnt und wobei die einzelnen Codeworte um einen Zahn versetzt einander überlagert sind. Ein derartiger Code wird als Kettencode bezeichnet. Die Maßnahmen zum Auffinden eines derartigen Kettencodes, bei dem die einzelnen Codeworte unterschiedlichen Inhalt haben und wobei gleichwohl fünf Schritte des neuen sechsstelligen Codeworts von dem benachbart stehenden Codewort übernommen sind, sollen an dieser Stelle nicht beschrieben werden und sind nicht Gegenstand der vorliegenden Erfindung.

In Fig. 1 sind die Detektoren 4 bis 6 zu erkennen, wobei die einzelnen Detektoren jeweils einen Lichtempfänger besitzen, der den durch die vorbeidrehenden Zähne modulierten Lichtstrom in elektrische Signale umwandeln. Die Codespur 3 weist nur einen einzelnen Detektor 6 auf, während die Inkrementalspur 2 mit zwei um 90° gegeneinander versetzte Detektoren bestückt ist, wobei die 90° sich auf die zugehörige Zahnfrequenz beziehen.

Fig. 2 und 3 zeigen die durch Impulsformer rechteckförmig zugeschnittenen Ausgangssignale der Detektoren 4 und 5, die als Kanal 1 und 2 bezeichnet werden. Fig. 4 stellt das zu Rechtecksignalen umgeformte Ausgangssignal des Detektors 6 dar. Die in den Fig. 2 bis 4 dargestellten Ausgangssignale stehen zeitgerecht übereinander. Aus den Fig. ist zu erkennen, daß die Zeitpunkte des Flankenwechsels in dem Kanal 1 und 2 jeweils die Abtastzeitpunkte für die Codespur gemäß Fig. 4 sind. Während einer Periode der Inkrementalspur wird also die Codespur viermal abgetastet bedingt durch die jeweils zwei Flankenwechsel an den Kanälen 1 und 2.

In den Fig. 5 bis 7 ist das erfinderische Prinzip dargestellt. Es wird angenommen, daß mit der steigenden Flanke an Inkrementalspur 2 das Lesen des zugehörigen Codeworts auf der Infospur beginnt. Zu diesem Zeitpunkt (Bit Nr. 1) wird auf der Infospur der Wert 0 gelesen. Bei der dann folgenden, ansteigenden Flanke der Inkrementalspur 1 zeigt die Infospur als Bit Nr. 2 wieder den Wert 0. Der nächste Abtastzeitpunkt der Infospur fällt mit der fallenden Flanke der Inkrementalspur 2 zusammen, wobei sich ein Wert "1" als Bit Nr. 3 ergibt. Bei den drei folgenden Flankenwechseln werden auf der Innenspur die Werte 001 als Bit Nr. 4, 5 und 6 gelesen. Man erhält so ein sechsschrittiges Bit-Wort. Um aber die gewünschten 240 unterschiedlichen Winkelwerte definieren zu können, wären an sich Codeworte notwendig, die 8 Bit besitzen. Erfindungsgemäß hilft man sich dadurch, daß man die Richtung des Flankenwechsels an den beiden Inkrementalspuren als zum Codewort gehörige Information hinzufügt, so daß sich insgesamt ein Codewort von 8 Bit ergibt. Dazu können beispielsweise die beiden ersten Flankenwechsel der Inkrementalspuren, die ja beide ansteigend sind, als Werte "1", "1" dem sechsschrittigen Code der Codespur in Fig. 7 hinzugefügt werden. Man kann sich das plastisch beispielsweise so vorstellen, daß die Folge der beiden ersten Flankenwechsel die Seiten einer Tabelle beschreiben, auf denen die zu den sechsschrittigen Codeworten gehörenden Winkelwerte in einer Tabelle ausgelesen werden sollen. So ergibt sich für den gleichen Code in der Auswerttabelle ein anderer Winkelwert je nachdem, ob die beiden zugehörigen Flankenwechsel der Inkrementalspuren 1 und 2 die Werte 11 bzw. 10 bzw. 00 oder 01 aufweisen. Dabei bleibt es der Definition überlassen, ob die beiden führenden Flankenwechsel auf der Inkrementalspur oder definierte nachfolgende Flankenwechsel wie z.B. die beiden nach dem gelesenen Codewort auftretenden Flankenwechsel zur Bezeichnung der Tabellenseiten verwendet werden.

Im Ergebnis ist aber festzuhalten, daß.durch die Erfindung der Absolutwert mit einer Genauigkeit von 8 Bit angegeben werden kann, obwohl die zugehörigen Codeworte auf der Infospur nur 6 Bit betragen.

## Patentansprüche

1. Lenkwinkelsensor zur Bestimmung des Absolutwertes des Fahrzeuglenkwinkels, mit einer Codescheibe (1), die eine Absolutspur (3) mit Codeworten für Absolutwerte der Codescheibenstellung und mindestens eine zusätzliche Inkrementalspur (2) zur Angabe der augenblicklichen schrittweisen Winkeländerung der Codescheibenstellung aufweist, mit wenigstens einem die Absolutspur (3) abtastenden Sensor (6) und wenigstens einem die Inkrementalspur (2) abtastenden Sensor (4,5), wobei die Ausgangssignale (Kanal 1, Kanal 2, Codespur) der Sensoren (4,5,6) ausgewertet und der Lenkwinkel bestimmt wird,
**dadurch gekennzeichnet, daß** zur Bestimmung des Absolutwerts des Fahrzeuglenkwinkels mit dem Lesen des Codeworts des Absolutwerts der Codescheibenstellung auch die Richtung des Flankenwechsels des Ausgangssignals (Kanal 1, Kanal 2) des augenblicklich gemessenen Zustands der Inkrementalspur ausgewertet wird.

2. Lenkwinkelsensor nach Anspruch 1, **dadurch gekennzeichnet, daß** die Inkrementalspur (2) durch zwei Sensoren (4,5) abgetastet wird, die zwei um 90° phasenverschobene Signale eines Inkrementalschrittes erzeugen.

3. Lenkwinkelsensor nach Anspruch 1 oder 2, **dadurch gekennzeichnet, daß** die Genauigkeit des tatsächlichen Absolutwertes derart definiert ist, daß dieser durch einen 8-Bit-Code eindeutig bestimmbar ist.

4. Lenkwinkelsensor nach Anspruch 3, **dadurch gekennzeichnet, daß** 2 Bit des 8 Bit-Codes durch die jeweiligen Flankenwechsel der zwei Ausgangswerte der zwei Sensoren (4,5) der Inkrementalspur (2) und 6 Bit durch einen aktuellen Kettencode auf der Absolutspur (3) bestimmt sind.

5. Lenkwinkelsensor nach einem der vorangegangenen Ansprüche, **dadurch gekennzeichnet, daß** der tatsächliche Absolutwert des Lenkwinkels einen von 240 unterschiedlichen Werten annehmen kann, so daß die Auflösung des Absolutwertes 1,5° beträgt.

6. Lenkwinkelsensor nach einem der Ansprüche 1 bis 5, **dadurch gekennzeichnet, daß** in einer Auswerteeinrichtung des Lenkwinkelsensors eine Tabelle vorgesehen ist, in der den bestimmten Codeworten die zugehörigen Winkelwerte zugeordnet sind.

## Claims

1. A steering angle sensor for the determination of the absolute value of the steering angle of a vehicle by means of a code disk (1), having an absolute track (3) with code words for absolute values of the position of the code disk and at least one additional incremental track (2) for indicating the momentary stepwise angle change of the position of the code disk, further having at least one the absolute track (3) scanning detector (6) and at least one the incremental track (2) scanning detector (4, 5), the output signals (channel 1, channel 2, code track) of the detectors (4, 5, 6) being evaluated and the steering angle being determined, **characterised in that** for the determination of the absolute value of the steering angle of the vehicle by reading the code word of the absolute value of the position of the code disk also the direction of the change of the flank of the output signal (channel 1, channel 2) of the actual measured condition of the incremental track is evaluated.

2. A steering angle sensor as claimed in claim 1, **characterised in that** the incremental track (2) is scanned by two detectors (4, 5), which create two signals which are phase shifted by 90° of an incremental step.

3. A steering angle sensor as claimed in claim 1 or in claim 2, **characterised in that** the precision of the actual absolute value is defined so that the same is unequivocally determinable by an 8-bit code.

4. A steering angle sensor as claimed in claim 3, **characterised in that** 2 bits of the 8-bit code are determined by the momentary change of the flank of the two output values of the two incremental sensors (4, 5) of the incremental track (2) and 6 bits are determined by a actual chain code on the absolute track (3).

5. A steering angle sensor as claimed in any of the preceding claims, **characterised in that** the actual absolute value of the steering angle may adopt any one of 240 different values so that the resolution of the absolute value is 1.5°.

6. A steering angle sensor as claimed in any of claims 1 through 5, **characterised in that** in an evaluation device of the steering angle sensor a table is provided wherein the pertinent angle values are assigned to the determined code words.

## Revendications

1. Capteur d'angle de braquage permettant de déterminer la valeur par rapport à l'origine de l'angle de braquage d'un véhicule, comprenant un disque codeur (1) qui comprend une piste à l'origine (3) comportant des mots codés pour des valeurs par rapport à l'origine de la position du disque codeur et au moins une piste incrémentielle (2) supplémentaire servant à indiquer la variation angulaire pas à pas instantanée de la position du disque codeur, au moins un capteur (6) lisant la piste à l'origine (3) et au moins un capteur (4, 5) lisant la piste incrémentielle (2), les signaux de sortie (Canal 1, Canal 2, Piste de code) des capteurs (4, 5, 6) étant analysés et l'angle de braquage étant déterminé,
**caractérisé en ce que**, pour la détermination de la valeur par rapport à l'origine de l'angle de braquage du véhicule, avec la lecture du mot codé de la valeur par rapport à l'origine de la position du disque codeur, le sens du changement de flanc du signal de sortie (Canal 1, Canal 2) de l'état mesuré instantané de la piste incrémentielle est également lu.

2. Capteur d'angle de braquage suivant la revendication 1, **caractérisé en ce que** la piste incrémentielle (2) est lue au moyen de deux capteurs (4, 5) qui produisent deux signaux d'un pas incrémentiel qui sont déphasés de 90°.

3. Capteur d'angle de braquage suivant la revendication 1 ou 2, **caractérisé en ce que** la précision de la valeur par rapport à l'origine effective est définie d'une manière telle que cette valeur par rapport à l'origine peut être déterminée d'une manière univoque par au moyen d'un code à 8 bits.

4. Capteur d'angle de braquage suivant la revendication 3, **caractérisé en ce que** 2 bits du code à 8 bits sont déterminés par les changements de flanc se présentant à chaque fois pour les deux valeurs de sortie des deux capteurs (4, 5) de la piste incrémentielle (2) et 6 bits sont déterminés par un code à enchaînement actuel présent sur la piste à l'origine (3).

5. Capteur d'angle de braquage suivant l'une des revendications précédentes, **caractérisé en ce que** la valeur par rapport à l'origine effective de l'angle de braquage peut prendre une valeur parmi 240 valeurs différentes, de sorte que la résolution de la valeur à l'origine vaut 1,5°.

6. Capteur d'angle de braquage suivant l'une des revendications 1 à 5, **caractérisé en ce que**, dans un dispositif d'analyse du capteur d'angle de braquage, il est prévu une table dans laquelle les valeurs d'angle considérées sont associés aux mots codés déterminés.
